Europäisches Patentamt

European Patent Office

Office européen des brevets

(19)

(11) Numéro de publication: **0 012 632**
A1

# (12) DEMANDE DE BREVET EUROPEEN

(21) Numéro de dépôt: 79400067.9

(22) Date de dépôt: 01.02.79

(51) Int. Cl.³: **H 04 N 7/12**, H 04 B 12/04

---

(30) Priorité: 08.12.78 FR 7835485

(43) Date de publication de la demande: 25.06.80
Bulletin 80/13

(84) Etats contractants désignés: **BE CH DE GB IT NL SE**

(71) Demandeur: **Etablissement Public de Diffusion dit "Télédiffusion de France"**, 21 -27 rue Barbès,
**F-92120 Montrouge (FR)**
Demandeur: **Kretz, Francis, 5, rue de la Croix-Connue,
F-35510 Cesson-Sevigne (FR)**
Demandeur: **Boudeville, Jean-Louis, 6, rue de la
Cotinière, F-35500 Vitre (FR)**

(72) Inventeur: **Kretz, Francis, 5, rue de la Croix-Connue,
F-35510 Cresson-Sevigne (FR)**
Inventeur: **Boudeville, Jean-Louis, 6, rue de la Cotinière,
F-35500 Vitre (FR)**

(74) Mandataire: **Le Guen, Louis François, 13, rue Emile Bara
BP 91, F-35800 Dinard (FR)**

(54) **Compression et expansion (quantification) de signaux numériques de télévision à codage différentiel.**

(57) Le codage des signaux de télévision à traiter ou transmettre sous forme numérique est effectué en utilisant la modulation d'impulsions codées différentielles (MICD).

On prévoit une caractéristique de quantification qui permet de réduire le débit numérique à transmettre ou traiter. La caractéristique est, au moins partiellement, non symétrique par rapport à zéro, en ce qui concerne le nombre et les valeurs des seuils et des niveaux de reconstruction des différences. Des exemples numériques sont donnés.

Dans une variante, la caractéristique de quantification varie en fonction de la valeur de prédiction $P_n$. La gamme de variation de la prédiction $P_n$ est découpée en zones de prédiction $Z_i$. A chaque zone de prédiction est associée une caractéristique de quantification. Les zones de prédiction ne sont pas symétriques par rapport à la mi-dynamique de la prédiction $P_n$. Les caractéristiques de quantification peuvent être ou non des segments d'une caractéristique étendue, qui est de préférence non symétrique.

Compression et expansion (quantification) de signaux
numériques de télévision à codage différentiel

La présente invention concerne la compression et l'expansion de
signaux numériques de télévision à codage différentiel.

Le codage des signaux de télévision destinés à être traités ou
transmis sous forme numérique et, plus particulièrement, ce codage en
utilisant la modulation d'impulsions codées différentielles (MICD, ou
en anglais DPCM) ont déjà fait l'objet de nombreuses études parmi
lesquelles on citera les articles suivants:

- "Predictive Quantizing Systems (Differential Pulse Code
  Modulation) for the Transmission of Television Signals" par
  J.B. O'Neal, paru dans la revue américaine "Bell System
  Technical Journal", vol. 45, pages 689 à 721, mai 1966,
- "A comparison of extended differential coding schemes for
  video signals" par H.G. Musmann, paru dans les actes du
  Séminaire de Zurich de 1974,
- "Systeme de codage numérique de l'image de télévision - le
  projet OCCITAN" par J. Poncin et J. Sabatier, paru dans la
  revue française "L'écho des recherches", janvier 1976, pages
  28 à 37,
- "Dégradation des signaux d'images et qualité subjective en codage
  numérique: visibilité du flottement de contour" par F. Kretz et
  J-L Boudeville, paru dans la revue française "Annales des
  Télécommunications", tome 31, N° 9-10, septembre-octobre 1976.

0012632

Dans le codage MICD, on code la différence entre la valeur réelle d'un échantillon de signal de télévision et une estimation de cette valeur calculée à partir d'échantillons codés voisins antérieurs. Les différences sont classées en zones autour de 0, les zones étant délimitées par des valeurs numériques ou seuils. Chaque valeur de différence située entre deux seuils est codée suivant une combinaison codée d'impulsion donnée et constante correspondant à la zone délimitée par les deux seuils. La largeur des zones croît avec le rang des zones quand on s'écarte de zéro, ce qui permet d'obtenir ce qu'il est convenu d'appeler une compression dans le codeur ou une expansion dans le décodeur. Les faibles différences sont donc codées finement afin d'éviter l'apparition de bruit granulaire, notamment dans les plages uniformes de l'image. Par contre, ce tassement des zones dans les faibles différences implique, le nombre des éléments binaires ou ebs par échantillon étant toujours limité, une plus grande imprécision du codage des grandes différences. On dit que la caractéris-tique de compression est alors non linéaire.

En général on n'a jusqu'ici utilisé que des caractéristiques de compression symétriques par rapport à zéro, bien que cela ne soit pas nécessairement un optimum du point de vue de l'effet visuel des défauts, comme il a été dit dans le troisième article technique cité ci-dessus. Toutefois, dans l'image reconstituée apparaissent trois types de défauts:

- un traînage consécutif à une dynamique de la caractéristique de quantification des différences insuffisante,
- un flottement de contour dû au codage différent d'une ligne à l'autre ou d'une image à l'autre d'une transition en présence de bruit, et
- le bruit granulaire qui apparaît sur les zones uniformes de façon analogue au bruit de source.

En pratique, on sait que la modulation simple par impulsions codées (ou MIC) d'un signal de télévision de définition courante conduit à un débit numérique prohibitif de l'ordre de 120 Meb/s. La modulation MICD permet une réduction de ce débit jusqu'à 45 Meb/s avec une qualité d'image couleur convenable en codant séparément les composantes. Toutefois ce débit de 45 Meb/s est exclu, au moins au plan des normalisations européennes discutées au CCITT en ce qui concerne les systèmes de transmission. Il faut donc prévoir un débit numérique qui corresponde au débit immédiate-ment inférieur d'un système de transmission normalisé, c'est à dire 34 Meb/s.

3   0012632

Il s'est avéré qu'en fixant le débit à 34 Meb/s pour un signal de télévision à 625 lignes échantillonné à 8,86 MHz, les défauts mentionnés ci-dessus rendaient la qualité de l'image insuffisante en n'utilisant qu'une caractéristique symétrique.

Dans le second article technique cité ci-dessus, on a proposé d'utiliser plusieurs caractéristiques, toujours symétriques, qui étaient commutées en fonction des propriétés locales de l'image. Il s'est avéré que, pour un débit de 34 Meb/s, on n'obtenait pas encore une qualité d'image suffisante.

Comme l'indique l'article technique intitulé "Source encoding with fixed word length and synchronous bit rate" par H.G. Musmann et paru dans les compte-rendus "IEEE CHO 601-5 National Television Conference Record" de 1972, pp. 27E-1 – 27E-6, on a également déjà proposé de faire varier la caractéristique de quantification suivant la valeur de prédiction $P_n$ concernant le point à coder.

Un objet de la présente invention consiste à prévoir une caractéristique qui permette de réduire le débit numérique dans les systèmes de codage numérique de l'image de télévision, tout en préservant une qualité d'image adéquate.

Suivant une caractéristique de l'invention, il est prévu une compression et une expansion correspondante de signaux numériques de télévision à codage différentiel MICD dans lesquelles la caractéristique de quantification est au moins partiellement non symétrique par rapport à zéro, en ce qui concerne le nombre et les valeurs des seuils et des niveaux de reconstruction des différences entre la valeur réelle d'un échantillon de signal de télévision et son estimation.

Suivant une autre caractéristique, ladite caractéristique comprend dans ses parties non symétriques, moins de niveaux pour la région des différences négatives que pour la région des différences positives.

Suivant une autre caractéristique, ladite caractéristique a une pente qui décroît plus vite dans la région négative que dans la région positive.

Suivant une caractéristique de la présente invention, il est prévu une caractéristique de quantification, qui est définie par le nombre et les valeurs de seuils et des niveaux de reconstruction et qui varie suivant la valeur de la prédiction $P_n$ concernant le point à coder, la gamme de variation de la prédiction $P_n$ étant découpée en zones de prédiction $Z_i$, i variant de $\underline{1}$ à $\underline{k}$, à chaque zone de prédiction $Z_i$

étant associée à une caractéristique de quantification $Q_i$, qui est invariante pour toutes les valeurs $X_n$ de l'échantillon à coder dont la valeur de prédiction $P_n$ est incluse dans la zone $Z_i$, mais variant d'une zone $Z_i$ à une autre, chaque caractéristique de quantification $Q_i$, comportant le même nombre $\underline{N}$ de valeurs de seuils et de niveaux de reconstruction, mais des niveaux extrêmes négatifs différents d'une zone de prédiction $Z_i$ à une autre, dans laquelle les zones de prédiction $Z_i$ ne sont pas symétriques par rapport à la mi-dynamique de la prédiction $P_n$.

Suivant une caractéristique, les caractéristiques de quantification $Q_i$ (seuils et niveaux) sont non symétriques les unes des autres par rapport au point correspondant à la mi-dynamique de $P_n$, les zones de prédiction $Z_i$ étant symétriques.

Suivant une autre caractéristique, les caractéristiques de quantification $Q_i$ sont des segments d'une caractéristique de quantification $Q'$, laquelle comporte un nombre de niveaux $\underline{N'}$ plus important que $\underline{N}$ .

Suivant une autre caractéristique, la caractéristique de quantification étendue $Q'$ est dissymétrique.

Par ailleurs, il faut bien comprendre que, dans le décodeur qui reçoit les signaux codés, on effectue le même calcul de prédiction que dans le codeur. Donc, on n'a pas d'information supplémentaire à transmettre du codeur au décodeur pour indiquer à ce dernier le numéro de la zone de prédiction $Z_i$ pour chaque point.

Les caractéristiques de l'invention mentionnée ci-dessus ainsi que d'autres apparaîtront plus clairement à la lecture de la description suivante d'exemples de réalisation mettant en oeuvre la quantification suivant l'invention, ladite description étant faite en relation avec les dessins joints, parmi lesquels:

la Fig. 1 est le bloc-diagramme d'un codeur MICD classique utilisé pour coder avec compression des signaux d'image de télévision,

la Fig. 2 est le bloc-diagramme d'un décodeur MICD classique utilisé pour reconstruire des signaux d'images de télévision,

la Fig. 3 montre la caractéristique de quantification utilisée tant dans le codeur de la Fig. 1 que dans le décodeur de la Fig. 2,

la Fig. 4 est le bloc-diagramme d'une variante du codeur de la Fig. 1,

la Fig. 5 est le bloc-diagramme d'une autre variante du codeur de la Fig. 1.

la Fig. 6a est un diagramme illustrant une méthode de codage suivant l'invention,

la Fig. 6b est un diagramme illustrant une variante de méthode de codage suivant l'invention,

la Fig. 7 est un bloc-diagramme d'un circuit de codeur fonctionnant suivant la méthode de codage illustrée à la Fig. 6b,

la Fig. 8 est un bloc-diagramme d'une variante du circuit de la Fig. 7, qui fonctionne également suivant la méthode de codage illustrée à la Fig. 6b,

la Fig. 9 est un bloc-diagramme d'un circuit de décodeur capable de décoder des signaux codés provenant du codeur de la Fig. 7 ou de celui de la Fig. 8,

la Fig. 10 est un bloc-diagramme d'un circuit de codeur fonctionnant suivant la méthode de codage illustrée à la Fig. 6a,

la Fig. 11 est un bloc-diagramme d'une variante du circuit de la Fig. 10, qui fonctionne également suivant la méthode de codage illustrée à la Fig. 6a, et

la Fig. 12 est un bloc-diagramme d'un circuit de décodeur capable de décoder des signaux codés provenant du codeur de la Fig. 10 ou de celui de la Fig. 11.

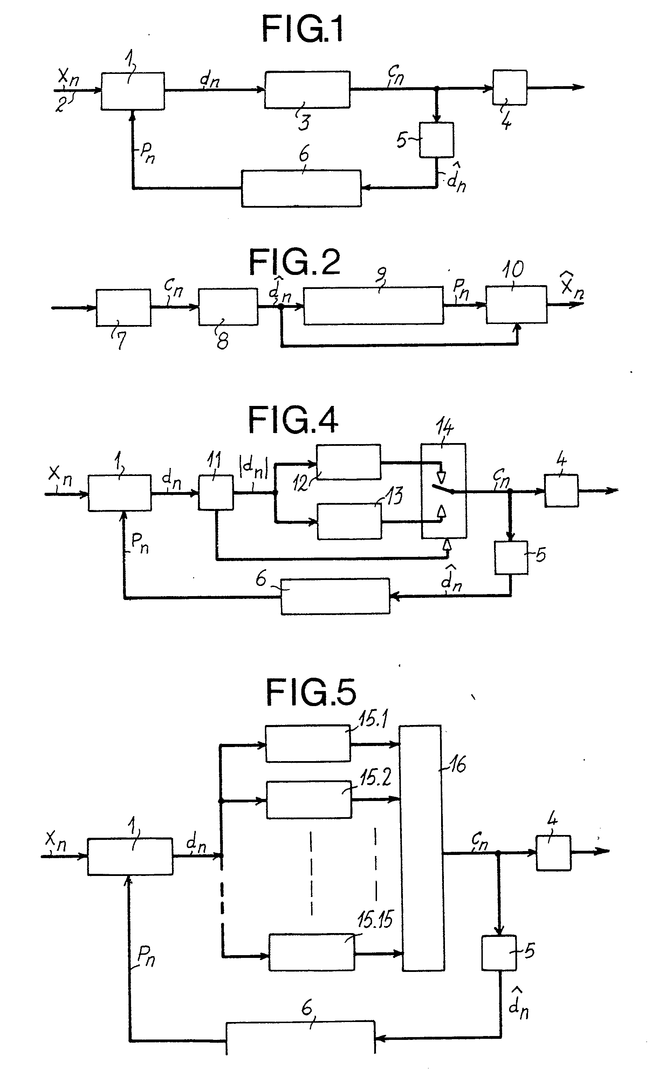

Le codeur MICD de la Fig. 1 comprend un soustracteur algébrique 1 dont la première entrée est reliée à l'entrée de signal 2 à laquelle est appliquée le signal d'image de télévision à coder, et dont la sortie est reliée à l'entrée d'un circuit quantificateur 3 dont la sortie est, d'une part, reliée à un circuit d'utilisation 4, tel par exemple qu'un organe de transmission, et, d'autre part, reliée à un convertisseur 5. La sortie du convertisseur 5 est reliée à l'entrée d'un circuit prédicteur 6 dont la sortie est reliée à la seconde entrée du soustracteur 1.

Dans l'exemple de réalisation décrit, on suppose que le signal d'image de télévision appliqué à l'entrée 2 se trouve sous forme numérique $X_n$ et est délivré par un codeur classique MIC, non montré. Le soustracteur 1 effectue la différence $d_n$ entre le signal numérique $X_n$ et un signal numérique de prédiction $P_n$ délivré par le circuit prédicteur 6. Le circuit quantificateur 3 peut être constitué par une mémoire morte de codage dans laquelle les valeurs $d_n$ délivrées par le soustracteur 1 sont considérées comme des adresses auxquelles correspondent des signaux MICD $C_n$ qui sont lus pour être appliqués au circuit 4 qui les transmet.

Par ailleurs, les signaux numériques $C_n$ sont également appliqués au convertisseur 5. Le convertisseur 5 peut être constitué par une mémoire morte de décodage dans laquelle les valeurs $C_n$ sont considérées comme des adresses auxquelles correspondent des signaux numériques $\hat{d}_n$ qui constituent classiquement les différences reconstruites. Le circuit prédicteur 6, qui peut être classique, consiste en une mémoire dans laquelle sont emmagasinées les informations numériques relatives à certains points de l'image précédant le point courant auquel correspond le signal $X_n$. En ce qui concerne les formules de prédiction qui peuvent être mises en oeuvre dans le circuit 6, on pourra se reporter utilement aux second et troisième articles techniques cités dans le préambule de la présente description. Le circuit 6 délivre pour chaque point le signal numérique de prédiction $P_n$.

Il apparaîtra que la loi de correspondance entre les valeur $d_n$ et $C_n$ dans le quantificateur 3, d'une part, et la loi de correspondance entre les valeurs $C_n$ et $\hat{d}_n$ dans le convertisseur 5, d'autre part, forme la caractéristique de compression et d'expansion (c'est à dire de quantification) des différences.

Dans l'exemple de réalisation de l'invention, la loi de correspondence entre les valeurs $d_n$ et $C_n$ est indiquée dans le tableau I suivant.

Tableau I

| Valeur de $d_n$ comprise entre | | | Valeur de $C_n$ |
|---|---|---|---|
| − 255 | et | − 70 | 1 |
| − 69 | et | − 50 | 2 |
| − 49 | et | − 33 | 3 |
| − 32 | et | − 19 | 4 |
| − 18 | et | − 9 | 5 |
| − 8 | et | − 3 | 6 |
| − 2 | et | 2 | 7 |
| 3 | et | 8 | 8 |
| 9 | et | 18 | 9 |
| 19 | et | 32 | 10 |
| 33 | et | 47 | 11 |
| 48 | et | 64 | 12 |
| 65 | et | 83 | 13 |
| 84 | et | 104 | 14 |
| 105 | et | 127 | 15 |
| 128 | et | 255 | 16 |

A chaque valeur de $C_n$ correspond une plage de valeurs $d_n$ définie par deux seuils. D'après le Tableau I, il apparaît que le nombre de ces plages, de part et d'autre de la valeur $d_n = 0$, n'est pas symétrique et que les largeurs de ces plages ne sont pas symétriques quand on s'écarte notablement de cette valeur. Dans le tableau I, on suppose que l'on utilise un codage MIC du signal à coder comportant 8 éléments binaires, avec la convention positive, où le blanc extrême est codé 255 et le noir extrême 0. A une valeur $d_n$ positive correspond donc dans le codage MICD, une valeur de luminance $X_n$ supérieure à la valeur de prédiction $P_n'$, c'est à dire un point plus blanc que ce que la valeur de prédiction ferait prévoir. A une valeur $d_n$ négative correspond un point plus sombre que prévu.

La loi de correspondance entre les valeurs $C_n$ et $\hat{d}_n$ est indiquée dans le tableau II suivant.

Tableau II

| Valeur de $C_n$ | Valeur de $\hat{d}_n$ |
|---|---|
| 1 | − 80 |
| 2 | − 58 |
| 3 | − 40 |
| 4 | − 25 |
| 5 | − 12 |
| 6 | − 4 |
| 7 | 0 |
| 8 | 4 |
| 9 | 12 |
| 10 | 25 |
| 11 | 39 |
| 12 | 55 |
| 13 | 73 |
| 14 | 93 |
| 15 | 115 |
| 16 | 140 |

On peut remarquer que, sauf à proximité de 0, les valeurs de $\hat{d}_n$ sont sensiblement dissymétriques, les valeurs positives étant plus nombreuses et atteignant des valeurs plus élevées que les valeurs négatives.

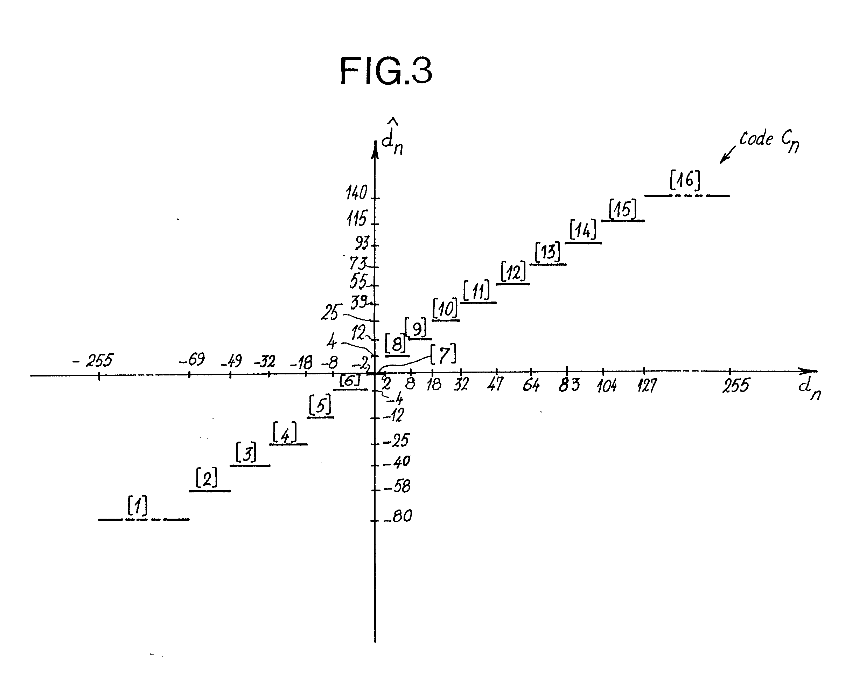

Les valeurs indiquées dans les tableaux I et II ont été choisies à la suite d'essais subjectifs. Bien entendu, les valeurs des seuils et des niveaux de reconstruction pourraient varier un peu, par exemple de l'ordre de 25 % pour les valeurs éloignées de Zéo et de $\pm$ 4 unités pour les valeurs proches de O . La Fig. 3 représente la caractéristique de compression et d'expansion (ou de quantification) tirée des tableaux I et II.

Bien entendu, avec un codage MIC à convention négative, il faudrait inverser le signe de $d_n$. Par ailleurs, quand on utilise d'une manière plus générale un codage MIC à n éléments binaires pour $X_n$, au lieu de 8 éléments binaires, comme on l'a supposé dans les tableaux I et II, les valeurs indiquées des seuils et des niveaux de reconstruction doivent être multipliées par $2^{n-8}$ et, éventuellement, arrondies à l'entier de module inférieur.

Le décodeur MICD de la Fig. 2 comprend un organe de réception 7 qui reçoit les signaux numériques transmis par l'organe de transmission 4 de la Fig. 1 et qui délivre les signaux $C_n$ reçus à un circuit convertisseur 8. La sortie du convertisseur 8 est reliée, d'une part, à un circuit prédicteur 9, d'autre part, à la première entrée d'un circuit additionneur 10. La sortie du circuit prédicteur 9 est reliée à la seconde entrée du circuit additionneur 10. Le circuit 10 délivre le signal reconstitué $\hat{X}_n$, qui est appliqué, après une conversion numérique-analogique à un récepteur de télévision, non montré. Le décodeur de la Fig. 2 a donc une structure classique. Le convertisseur 8 est identique au convertisseur 5 de la Fig. 1 tandis que le prédicteur 9 est identique au prédicteur 6 de la Fig. 1. Donc le convertisseur 8 délivre les signaux numériques $\hat{d}_n$ tandis que le prédicteur 9 délivre les signaux numériques $P_n$. Dans 10, l'addition de $\hat{d}_n$ et de $P_n$ donne la valeur reconstruite $\hat{X}_n$.

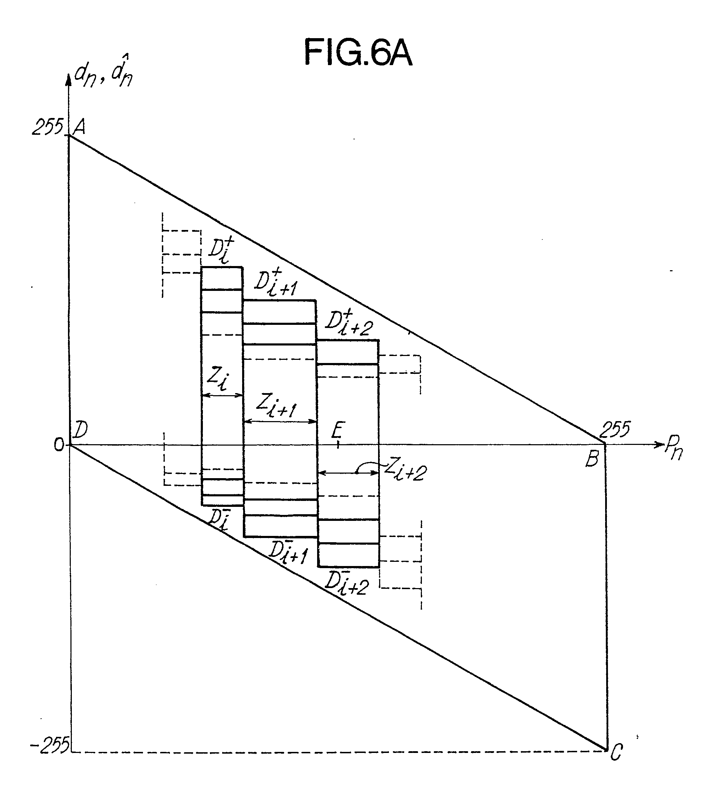

Le codeur MICD de la Fig. 4 constitue une variante du circuit de la Fig. 1. Il comprend un circuit soustracteur 1 qui reçoit le signal $X_n$ à coder, à sa première entrée, et le signal de prédiction $P_n$, à sa seconde entrée. La sortie du circuit 1 est reliée à l'entrée d'un circuit classique 11, prévu pour délivrer à sa première sortie la valeur absolue du signal numérique qui est appliquée à son entrée et à sa seconde sortie le signe de ce signal numérique. La première sortie de 11 est reliée, en parallèle, aux entrées d'adresses de deux mémoires mortes 12 et 13. La sortie de données de la mémoire 12 est reliée au premier contact d'un inverseur 14 tandis que la sortie de données de la mémoire 13 est reliée au second contact de l'inverseur 14. La sortie de ce signe du circuit 11 est reliée à l'entrée de commande de l'inverseur 14. Le contact mobile de 14 est relié, d'une part, à l'organe de transmission 4 et, d'autre part, à l'entrée du convertisseur 5 dont la sortie est reliée à l'entrée du prédicteur 6 dont la sortie est reliée à la seconde entrée de 1. Ainsi, à la Fig. 4, l'ensemble des circuits 11 à 14 remplace le circuit 3.

La première sortie de 11 délivre la valeur absolue $\left|d_n\right|$. La mémoire 12 utilise les valeurs absolues qui lui sont appliquées comme des adresses pour délivrer les valeurs $C_n$ 7 à 16 conformément à la partie inférieure du tableau I. La mémoire 13 utilise les valeurs absolues qui lui sont appliquées comme des adresses pour délivrer les valeurs $C_n$ 1 à 6 conformément à la partie supérieure du tableau I. Selon la valeur + ou - du signe de $d_n$ fournie par 11, l'inverseur 14 commute la sortie de 12 ou de 13 vers 4 et 5. On retrouve bien la fonction de la mémoire 3 de la Fig. 1.

Le codeur MICD de la Fig. 5 constitue une autre variante du circuit de la Fig. 1. Au lieu de la mémoire 3, il comprend un groupe de 15 comparateurs 15.1 à 15.15 dont les entrées respectives sont reliées en parallèle à la sortie du soustracteur 1 et dont les sorties sont reliées aux entrées correspondantes d'un transcodeur 16. Les comparateurs 15.1 à 15.15 déterminent les bornes des zones de $d_n$ indiquées dans la première colonne du tableau I et le résultat en est déduit dans le transcodeur 16 qui délivre les signaux numériques $C_n$. Les détails des comparateurs et du transcodeur sont classiques dans la technique du traitement des informations.

A la Fig. 6a, on a représenté des zones de prédiction $Z_i$ dans un système de coordonnées avec en abscisse $P_n$, valeur de prédiction, et en ordonnée $d_n$, et donc $\hat{d}_n$. On suppose que $P_n$ peut prendre une valeur quelconque entre $\underline{0}$ et $\underline{255}$, ce qui correspond à un codage MIC à 8 éléments binaires. Donc $d_n$ et $\hat{d}_n$ peuvent prendre des valeurs comprises entre $-\underline{255}$ et $+\underline{255}$, en cas de convention positive, comme on l'a défini plus haut.

Dans la méthode illustrée à la Fig. 6a, les zones de codage $C_n$ sont fonctions à la fois de $d_n$ et de $P_n$, tandis que les niveaux de reconstruction $\hat{d}_n$ sont également fonctions de $C_n$ et de $P_n$, avec la simplification suivante: dans chaque zone de prédiction $Z_i$, $\underline{i}$ variant de

$\underline{1}$ à $\underline{k}$, la caractéristique de quantification est invariante, ce qui se traduit par les formules:

$$C_n = f (d_n, i) \qquad et \qquad \hat{d}_n = g (C_n, i)$$

si $P_n$ est dans la zone de prédiction $Z_i$.

Il apparaît que les zones $Z_i$ à $Z_k$ juxtaposées recouvrent l'axe de DB du parallèlogramme ABCD, dont les côtés représentent les limites théoriques de l'erreur de prédiction $d_n = X_n - P_n$ en fonction de $P_n$. En pratique, ces limites ne sont jamais atteintes et les valeurs de $d_n$, dans chaque zone $Z_i$, peuvent être limitées à des valeurs inférieures en valeur absolue, telles que $D_i^+$ et $D_i^-$. Comme le montre la Fig. 6a, les zones $Z_i$ sont de largeur variable et les niveaux extrêmes $D_i^+$ et $D_i^-$ sont également variables. On notera également que les différents niveaux de reconstruction et seuils dans les zones ne coincident pas d'une zone à la zone adjacente. De plus, de préférence, les zones $Z_i$ ne sont pas symétriques par rapport au point E se trouvant sur l'axe des abscisses au milieu de DB et marquant la mi-dynamique de P. Même si les zones sont symétriques par rapport à E, les caractéristiques de quantification $Q_i$ (seuils et niveaux) ne sont pas symétriques les unes des autres par rapport à E.

Dans chaque zone $Z_i$, on prévoit N niveaux, y compris $D_i^+$ et $D_i^-$, qui ne sont pas symétriques par rapport au point dont l'ordonnée est nulle $(d_n = 0)$, mais de préférence sont distribués d'une manière analogue à la distribution des 16 niveaux de la Fig. 3. $\underline{N}$ peut être égal à $\underline{16}$ ce qui correspond pour les codes $C_n^i$ à des mots de 4 éléments binaires.

A la Fig. 6a, on a notamment montré trois zones $Z_i$, $Z_{i+1}$ et $Z_{i+2}$, dont les largeurs sont manifestement différentes, ceci simplement à titre d'exemple.

Dans la pratique, les largeurs et la distributions des zones $Z_i$, suivant l'axe des abscisses, les valeurs de $D_i^-$ et $D_i^+$ et les caractéristiques de quantification $Q_i$ sont déterminées par l'expérience et choisies à la suite d'essais subjectifs.

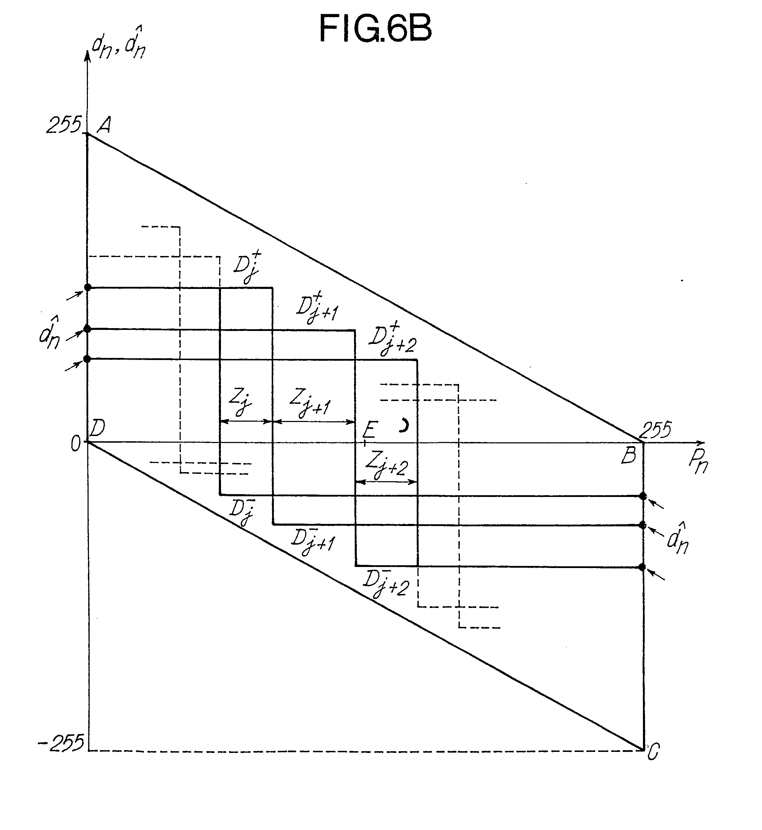

A la Fig. 6b, on a encore représenté des zones de prédiction $Z_j$ dans un parallèlogramme ABCD identique à celui de la Fig. 6a. Comme les zones $Z_i$, les zones $Z_j$ sont adjacentes, ont des largeurs différentes, sont distribuées non symétriquement par rapport au point E et couvrent la plus grande partie du rectangle ABCD. Par contre elles en sont différentes en ce qui concerne la distribution des seuils. En effet, les $\underline{N}$ seuils de chaque caractéristique de quantification de chaque zone

$Z_j$ sont pris parmi les $\underline{N}$'seuils d'une même caractéristique de quantification étendue, $\underline{N}'$ étant nettement plus grand que $\underline{N}$, les $\underline{N}$ seuils pris dans la caractéristique étendue pour former $\underline{N}$ seuils d'une zone $Z_j$ étant consécutifs. Il en résulte évidemment que les niveaux de reconstruction extrêmes $D_j^+$ et $D_j^-$ d'une zone $Z_j$ correspondent à des niveaux de la caractéristique de quantification étendue séparés par N-2 niveaux.

Ainsi, dans le cas illustré à la Fig. 6b, les niveaux de reconstruction et les zones de codage constituent une caractéristique de quantification $Q_j$ partielle de la caractéristique de quantification étendue $Q'$. Cette méthode de codage MICD à zones de prédiction consiste donc à ramener sur les niveaux de saturation $D_j^-$ et $D_j^+$ (propres à la zone de prédiction), dans chaque zone $Z_j$, les niveaux de reconstruction d'une caractéristique de quantification étendue $Q'$ qui leur sont extérieurs et à supprimer les zones de codage associées à ces niveaux masqués.

La caractéristique de quantification étendue $Q'$ est définie à la suite d'essais subjectifs, ainsi que les zones $Z_j$ et les niveaux de saturation $D_j^-$ et $D_j^+$. La qualité de l'image obtenue avec le codage à zones de prédiction de la Fig. 6b est normalement voisine de celle qui serait fournie par le codage MICD à quantificateur unique défini par la caractéristique $Q'$. L'avantage est bien entendu qu'à qualité pratiquement égale, le codage à zones de prédiction n'a besoin que de $\underline{N}$ mots de code pour assurer la transmission au lieu de $\underline{N}'$. Ainsi, si on choisit, par exemple, $\underline{N}$ égal à 16 et N' de l'ordre de $\underline{32}$, il apparaît que la présente invention présente un avantage important par rapport à la méthode utilisée dans le codeur de la Fig. 1 en permettant avec des mots transmis de même longueur d'obtenir une qualité d'image nettement supérieure, puisque tout se passe comme si le nombre des niveaux était double.

De préférence, on choisit pour la caractéristique de quantification étendue $Q'$ de préférence une forme dissymétrique. De plus, les zones de prédiction $Z_j$ sont choisies non symétriques par rapport au point E. Comme la caractéristique $Q'$ n'est pas symétrique, l'ensemble des valeurs de saturation positive $D_j^+$ n'est pas symétrique de l'ensemble des valeurs de saturation négative $D_j^-$ par rapport à E.

On peut aussi prévoir une méthode légèrement sous-optimale en utilisant une caractéristique de quantification étendue symétrique, mais dans laquelle ni les zones de prédiction $Z_j$, ni les ensembles de valeurs de saturation positive et négative ne sont symétriques par rapport au point E.

Les tableaux III et IV ci-après donnent les valeurs numériques d'un exemple de mise en oeuvre d'une telle méthode légèrement sous-optimale.

La caractéristique de quantification étendue est définie dans le tableau III. Elle comporte 31 codes $C'_n$. Les zones de prédiction et les valeurs de saturation sont définies dans le tableau IV. Le débit numérique est, dans cet exemple de 4 ebs par point, avec pour objectif un codage de signaux de télévision à 34 Meb/s. On a pu, au cours d'essais, observer que la qualité subjective de l'image présentée est meilleure que celle que l'on peut obtenir avec une caractéristique de quantification à 16 niveaux, comme dans le brevet principal, sans masquage selon la zone de prédiction. L'examen des tableaux III et IV fait encore ressortir qu'il a été rajouté , près des valeurs extrêmes 0 et 255 de $P_n$, des zones de prédiction telles que les valeurs de saturation $D_j^-$ et $D_j^+$ soient toujours dans le parallélogramme ABCD, quelle que soit la valeur de $P_n$. Ce procédé permet d'éminer la correction de débordement nécessaire classiquement dans le calcul de prédiction. Il faut noter que le même procédé peut être utilisé dans la méthode illustrée dans la Fig. 6a.

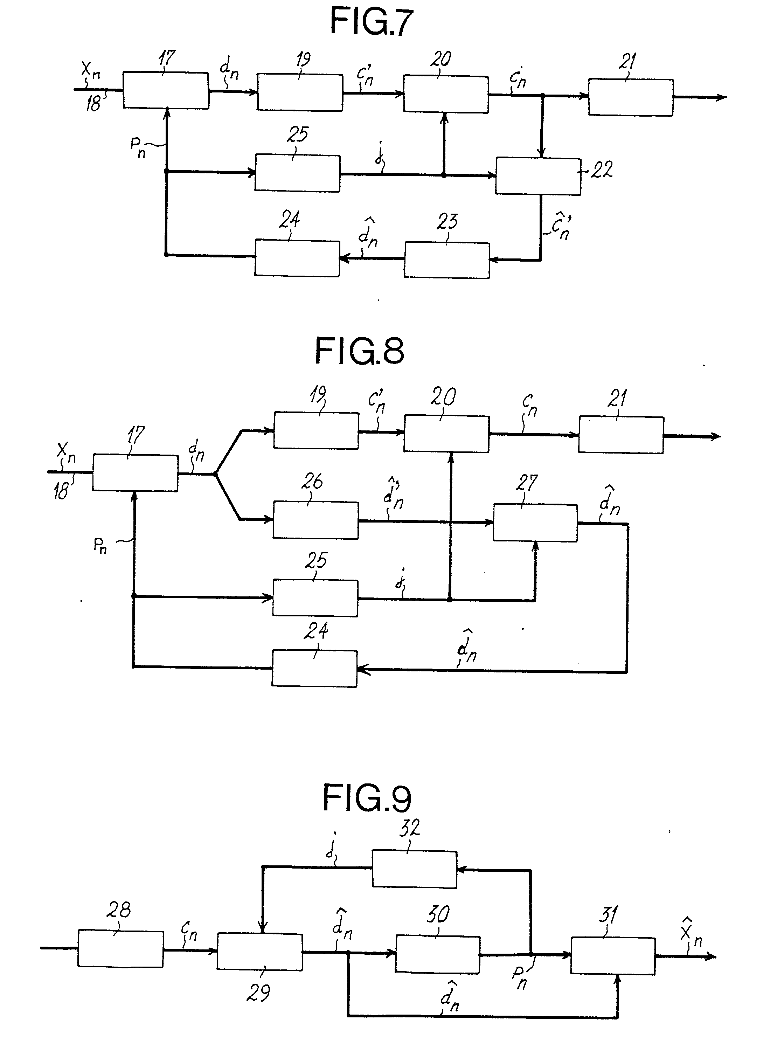

Un exemple de réalisation d'un codeur à caractéristique étendue, fonctionnant suivant la méthode illustrée à la Fig. 6b, est montré à la Fig. 7. Ce codeur comprend un soustracteur algébrique 17 dont la première entrée est reliée à l'entrée de signal 18 à laquelle est appliquée le signal de télévision à coder, et dont la sortie est reliée à l'entrée d'un circuit quantificateur 19. La sortie du circuit 19 est reliée à l'entrée d'un transcodeur-réducteur 20 dont la sortie est, d'une part, reliée à un circuit d'utilisation 21, tel que par exemple un organe de transmission, et, d'autre part, reliée à un transcodeur 22, inverse du transcodeur 20. La sortie du transcodeur 22 est reliée à l'entrée d'un convertisseur 23 dont la sortie est reliée à l'entrée d'un circuit prédicteur 24 dont la sortie est reliée à la seconde entrée du soustracteur 17. La sortie du prédicteur 24 est également reliée à l'entrée d'un codeur de zone de prédiction 25 dont la sortie est reliée, d'une part, à l'entrée de commande du transcodeur 20 et, d'autre part, à l'entrée de commande du transcodeur 22.

Dans l'exemple de réalisation décrit, on suppose que le signal d'image de télévision appliqué à l'entrée 18 se trouve sous forme numérique $X_n$ et est délivré par un codeur classique MIC, non montré. Le soustracteur 17 effectue la différence $d_n$ entre le signal numérique $X_n$ et un signal numérique de prédiction $P_n$ délivré par le prédicteur 24. Le circuit quantificateur 19 peut être constitué par une mémoire morte de codage dans laquelle les valeurs $d_n$ sont considérées comme des adresses

13                                        0012632

| Valeurs de $d_n$ (seuils) | Codes $C'_n$ | Niveau de reconstruction $\hat{d}_n$ |
|---|---|---|
| -255 à -231 | 1 | -245 |
| -230 à -202 | 2 | -215 |
| -201 à -176 | 3 | -188 |
| -175 à -153 | 4 | -163 |
| -152 à -131 | 5 | -141 |
| -130 à -110 | 6 | -119 |
| -109 à - 91 | 7 | - 99 |
| - 90 à - 74 | 8 | - 81 |
| - 73 à - 58 | 9 | - 65 |
| - 57 à - 44 | 10 | - 50 |
| - 43 à - 32 | 11 | - 37 |
| - 31 à - 20 | 12 | - 25 |
| - 19 à - 11 | 13 | - 14 |
| - 10 à - 4 | 14 | - 6 |
| - 3 à - 1 | 15 | - 2 |
| 0 | 16 | 0 |
| 1 à 3 | 17 | 2 |
| 4 à 10 | 18 | 6 |
| 11 à 19 | 19 | 14 |
| 20 à 31 | 20 | 25 |
| 32 à 43 | 21 | 37 |
| 44 à 57 | 22 | 50 |
| 58 à 73 | 23 | 65 |
| 74 à 90 | 24 | 81 |
| 91 à 109 | 25 | 99 |
| 110 à 130 | 26 | 119 |
| 131 à 152 | 27 | 141 |
| 153 à 175 | 28 | 163 |
| 176 à 201 | 29 | 188 |
| 202 à 230 | 30 | 215 |
| 231 à 255 | 31 | 245 |

Tableau III

Valeurs des seuils, des codes et des niveaux de reconstruction
de la caractéristique de quantification étendue.

| Valeurs de $P_n$ (limites des zones) | numéro de zone | Niveau de saturation positive | Niveau de saturation négative |
|---|---|---|---|
| 0 à 1 | 1 | 245 | 0 |
| 2 à 9 | 2 | 215 | -2 |
| 10 à 29 | 3 | 188 | -6 |
| 24 à 49 | 4 | 163 | -14 |
| 50 à 73 | 5 | 141 | -25 |
| 74 à 95 | 6 | 119 | -37 |
| 96 à 112 | 7 | 99 | -50 |
| 113 à 132 | 8 | 81 | -65 |
| 133 à 148 | 9 | 65 | -81 |
| 149 à 165 | 10 | 50 | -99 |
| 166 à 192 | 11 | 37 | -119 |
| 193 à 220 | 12 | 25 | -141 |
| 221 à 241 | 13 | 14 | -163 |
| 242 à 249 | 14 | 6 | -188 |
| 250 à 253 | 15 | 2 | -215 |
| 254 à 255 | 16 | 0 | -245 |

Tableau IV

Limites des zones de prédiction, numéro des zones et
niveau de saturation positive et négative.

auxquelles correspondent des signaux numériques $C'_n$ en nombre $\underline{k}'$ suivant la caractéristique de quantification étendue $Q'$. Si la caractéristique étendue correspond au tableau III, on a 31 signaux $C'_n$ possibles. Par ailleurs, le codeur 25 délivre en fonction de la valeur du signal numérique $P_n$ un signal numérique $\underline{i}$, lequel définit, comme on l'a décrit ci-dessus, des valeurs extrêmes de codes $C'_n$, c'est à dire les valeurs $C^+_i$ et $C^-_i$. Quand le signal $C'_n$ délivré par 19 est compris entre $C^-_i$ et $C^+_i$, il peut être simplement transmis à la sortie du transcodeur 20 un signal de différence de niveaux égal à $(C'_n - C^-_i)$. Quand $C'_n < C^-_i$, le transcodeur 20 délivre un signal de valeur 0 et quand $C'_n > C^+_i$, il délivre un signal de valeur $\underline{k}$, $\underline{k}$ étant égal dans l'exemple décrit à $\underline{15}$. On a indiqué que le transcodeur 20 délivre les codes $C_n$ correspondant à ces valeurs, lesquels sont lus pour être appliqués au circuit 21 qui les transmet.

Par ailleurs, les signaux numériques $C_n$ sont également appliqués au convertisseur 22 dont l'entrée de commande reçoit également la valeur $\underline{i}$. Le convertisseur 22 effectue l'opération inverse de celle qu'a effectuée le transcodeur 20, c'est à dire dans l'exemple pris ci-dessus, qu'il ajoute au signal $C_n$ reçu de 20 la valeur $C^-_i$, afin de délivrer un signal $\hat{C}'_n$. Il faut noter que, si la valeur de $C'_n$ tombait dans l'intervalle $C^-_i$, $C^+_i$ défini dans 20 par la valeur $\underline{i}$ délivrée par 25, la valeur $C_n$, délivrée par 22 est identique à $C'_n$, car le transcodeur inverse 22 reçoit le même signal $\underline{i}$ de 25.

Les signaux numériques $\hat{C}'_n$ sont appliqués au convertisseur 23, lequel peut être constitué par une mémoire de décodage dans laquelle les valeurs $\hat{C}'_n$ sont considérées comme des adresses auxquelles correspondent des signaux numériques qui constituent classiquement les différences reconstruites. Le circuit prédicteur 24, qui peut être classique comme le circuit 6 du brevet principal, délivre pour chaque point le signal numérique de prédiction $P_n$.

Ce signal $P_n$ est bien entendu appliqué classiquement à la seconde entrée du soustracteur 17, mais également à l'entrée du codeur 25, lequel peut être un simple discriminateur de niveaux de signaux numériques. Si l'on considère l'exemple des valeurs données dans le tableau IV, il apparaît qu'à une valeur de $P_n$ compris entre $\underline{0}$ et $\underline{255}$ corresponde un numéro de zone $\underline{i}$ compris entre 1 et 16 inclus. Le codeur 25 peut être une mémoire de décodage très simple, comme 19 et 23.

Le codeur de la Fig. 8 constitue une variante de celui de la Fig. 7 et comprend également les circuits 17, 19, 20, 21, 24 et 25 fonctionnant comme dans le codeur de la Fig. 7. Les circuits 22 et 23 sont remplacés par deux circuits 26 et 27. Le circuit 26 a son entrée de signal reliée à la sortie de 17 et sa sortie de signal reliée à l'entrée de signal du circuit 27 dont la sortie est reliée à l'entrée du prédicteur 24. L'entrée de commande du circuit 27 est reliée à la sortie du codeur de zones 25. Le circuit 26 est un codeur qui délivre, en fonction du signal numérique $d_n$ qui lui est appliqué, un autre signal numérique $\hat{d}'_n$ en suivant une table de correspondance qui, par exemple, peut être celle du tableau Ia. En pratique, le circuit 26 peut être une mémoire morte dans laquelle aux adresses $d_n$ sont enregistrées directement les valeurs numériques des signaux $\hat{d}'_n$. Le circuit 27 est un limiteur qui limite les valeurs $\hat{d}'_n$ aux valeurs extrêmes positives $D^+_i$ et négatives $D^-_i$ définies en fonction de $\underline{i}$ d'après le tableau Ib, et qui donc délivre un signal numérique $\hat{d}_n$, identique à celui délivré par 23 à la Fig. 7. En pratique, le circuit 27 peut être aussi une mémoire morte contenant les valeurs $D^+_i$ et $D^-_i$, associé à deux comparateurs logiques.

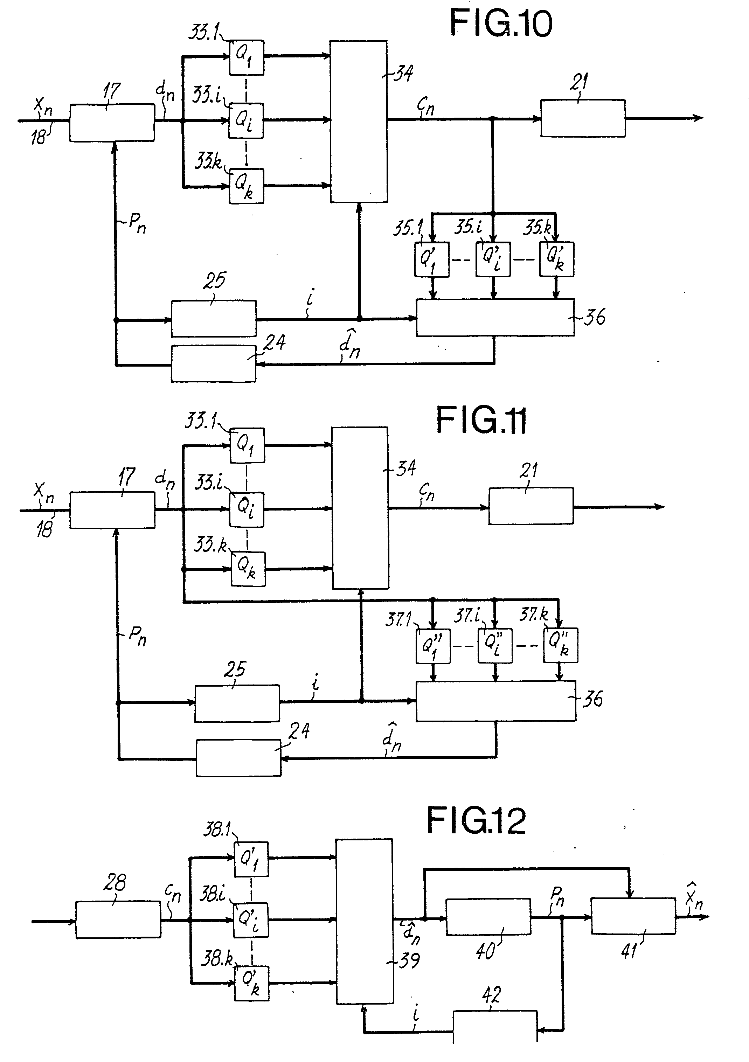

Le décodeur MICD de la Fig. 9 est prévu pour recevoir des signaux codés, suivant la méthode illustrée à la Fig. 6b, c'est à dire des signaux émis par le codeur de la Fig. 7 ou celui de la Fig. 8. Il comprend un organe de réception 28 qui reçoit les signaux numériques transmis par l'organe de transmission 21 des Figs. 7 et 8 et qui délivre les signaux $C_n$ reçus à un circuit convertisseur 29. La sortie du convertisseur 29 est reliée, d'une part, à un circuit prédicteur 30 et, d'autre part, à la première entrée d'un additionneur algébrique 31. La sortie du prédicteur 30 est reliée à la seconde entrée de l'additionneur 31, d'une part, et à l'entrée d'un codeur de zone 32, d'autre part. La sortie du codeur 32 est reliée à l'entrée de commande du convertisseur 29. En pratique, le circuit 29 comporte en série un circuit 22 et un circuit 23 de la Fig. 7 si bien que, comme 23, le circuit 29 délivre le même signal $\hat{d}_n$ que 23. En conséquence, le prédicteur 30, qui est identique au prédicteur 24, délivre le même signal $P_n$ qui est appliqué au codeur 32, qui, identique à 25, délivre le même code $\underline{i}$ indiquant la zone de prédiction. Il apparaît donc clairement qu'effectuant les mêmes opérations numériques dans le codeur et le décodeur, on n'a pas à transmettre en ligne d'autres informations que $C_n$. Bien entendu, à chaque début de ligne d'image de télévision et éventuellement au début de chaque image quand le prédicteur est bidimensionnel, le codeur et le décodeur sont placés par des moyens propres dans les mêmes conditions initiales.

Enfin, l'additionneur 31 fait la somme de $P_n$ et de $\hat{d}_n$ ce qui, classiquement, donne la valeur reconstruite $\hat{X}_n$, lequel est, après une conversion numérique-analogique, appliqué à un récepteur de télévision non montré.

Un exemple de réalisation d'un codeur à commutation de caractéristiques de quantification fonctionnant suivant la méthode illustrée à la Fig. 6a, est montré à la Fig. 10. Ce codeur comprend un soustracteur algébrique 17 dont une entrée reçoit le signal $X_n$ et l'autre le signal prédit $P_n$. La sortie de 17 est reliée en parallèle aux entrées de quantificateurs 33.1 à 33.k ayant respectivement des caractéristiques de quantifications $Q_1$ à $Q_k$. Les sorties des quantificateurs 33.1 à 33.k sont respectivement reliées aux entrées d'un sélecteur 34 dont la sortie est reliée, d'une part, à un organe de transmission 21, et, d'autre part, en parallèle aux entrées de convertisseurs 35.1 à 35.k. Les sorties des convertisseurs 35.1 à 35.k sont respectivement reliées aux entrées d'un sélecteur 36 dont la sortie est reliée à l'entrée du prédicteur 24. La sortie du codeur est reliée, en parallèle, aux entrées de commande des sélecteurs 34 et 36.

Chaque quantificateur 33.i a sa propre caractéristique $Q_i$, c'est à dire qu'en fonction de $d_n$ il applique à l'entrée correspondante de 34 un signal $C_n^i$. Le sélecteur 34 commandé par la sortie de 25 choisit un des signaux d'entrée pour le délivrer et il constitue alors le signal $C_n$, comme à la Fig. 7. Par ailleurs, tous les convertisseurs 35.1 à 35.k recevant le signal $C_n$ délivrent en fonction de leur caractéristiques inverses $Q'_1$ à $Q'_k$ les signaux $\hat{d}_n^i$ et le sélecteur 36, commandé par la sortie de 25, choisit la sortie de rang $\underline{i}$ pour la transmettre, ce qui donne $\hat{d}_n$.

Le codeur de la Fig. 11 est une variante de celui de la Fig. 10. On y retrouve les circuits 17, 33.1 à 33.k, 34, 21, 24, 25 et 36, mais les convertisseurs 37.1 à 37.k y remplacent les convertisseurs 35.1 à 35.k et ont leurs entrées respectives reliées en parallèle à la sortie du soustracteur 17. Ainsi, comme dans le codeur de la Fig. 10, le signal $d_n$ est directement, suivant un tableau analogue au tableau III, converti en signaux $\hat{d}_n^i$. Le fonctionnement des sélecteurs 34 et 36 est le même que précédemment.

En fait, cette méthode de codage, illustrée à la Fig. 6a, consiste à disposer d'autant de caractéristiques de quantification différentes $Q_i$-$Q'_i$ qu'il y a de zones de prédiction. Chacune possède le même nombre N de codes, comme dans les codeurs des Figs. 7 et 8, on n'a qu'une simple variante technique de la méthode de fonctionnement des codeurs des Figs. 7 et 8. Par contre, si les N codes sont adaptés à chaque zone de prédiction, indépendamment de ceux des autres zones, il est possible de suivre de plus près les résultats expérimentaux et d'obtenir ainsi une qualité légèrement supérieure pour un même nombre de codes.

La Fig. 12 montre un décodeur capable de recevoir les signaux transmis à partir de l'organe 21 des Figs. 10 et 11. Il comprend un organe de réception 28 dont la sortie est reliée, en parallèle, aux entrées de convertisseurs 38.1 à 38.k, identiques aux convertisseurs 35.1 à 35.K, dont les sorties sont reliées aux entrées d'un sélecteur 39, identique à 36. La sortie de 39 est reliée, d'une part, à l'entrée d'un prédicteur 40, identique à 24 et, d'autre part, à l'entrée d'un codeur de zone 42, identique à 25, dont la sortie est reliée à l'entrée de commande du sélecteur 39.

L'organe 28 délivre les signaux $C_n$. Comme 36, le sélecteur 39 délivre les signaux $\hat{d}_n$. Le prédicteur 40 délivre les signaux $P_n$ et donc le circuit 42 délivre le même code $\underline{i}$ que 25. L'additionneur 41 délivre le signal $\hat{X}_n$ qui est converti avant d'être appliqué à un téléviseur.

REVENDICATIONS

1) Compression et expansion (quantification) de signaux numériques de télévision à codage différentiel MICD, caractérisées en ce que la caractéristique de quantification est, au moins partiellement, non symétrique par rapport à zéro, en ce qui concerne le nombre et les valeurs des seuils et des niveaux de reconstruction des différences entre la valeur réelle d'un échantillon de signal de télévision et son estimation.

2) Compression et expansion (quantification) suivant la revendication 1, caractérisées en ce que ladite caractéristique de quantification comprend, dans ses parties non symétriques, moins de niveaux pour la région des différences négatives que pour la région des différences positives, quand le signal à coder est à convention positive, ou l'inverse dans le cas contraire.

3) Compression et expansion (quantification) suivant la revendication 2, caractérisées en ce que ladite caractéristique de quantification a une pente qui décroît plus vite dans la région négative que dans la région positive, quand le signal à coder est à convention positive, ou l'inverse dans le cas contraire.

4) Compression et expansion (quantification) suivant l'une des revendications 1 à 3, caractérisées en ce que la caractéristique de quantification d'un signal à codage MIC à 8 éléments binaires et en convention positive correspond aux tableaux I et II suivants:

Tableau I

| Valeur de $d_n$ comprise entre | | | Valeur de $C_n$ |
|---|---|---|---|
| − 255 | et | − 70 | 1 |
| − 69 | et | − 50 | 2 |
| − 49 | et | − 33 | 3 |
| − 32 | et | − 19 | 4 |
| − 18 | et | − 9 | 5 |
| − 8 | et | − 3 | 6 |
| − 2 | et | 2 | 7 |
| 3 | et | 8 | 8 |
| 9 | et | 18 | 9 |
| 19 | et | 32 | 10 |
| 33 | et | 47 | 11 |
| 48 | et | 64 | 12 |
| 65 | et | 83 | 13 |

2

0012632

| 84 | et | 104 | | 14 |
|---|---|---|---|---|
| 105 | et | 127 | | 15 |
| 128 | et | 255 | | 16 |

Tableau II

| Valeur de $C_n$ | Valeur de $\hat{d}_n$ |
|---|---|
| 1 | − 80 |
| 2 | − 58 |
| 3 | − 40 |
| 4 | − 25 |
| 5 | − 12 |
| 6 | − 4 |
| 7 | 0 |
| 8 | 4 |
| 9 | 12 |
| 10 | 25 |
| 11 | 39 |
| 12 | 55 |
| 13 | 73 |
| 14 | 93 |
| 15 | 115 |
| 16 | 140 |

dans lesquels $d_n$ est la différence entre la valeur du signal à coder et son estimation, $C_n$ la valeur décimale correspondant à la valeur en code MICD, et $\hat{d}_n$ la différence reconstruite, les valeurs des seuils et des niveaux de reconstruction étant données à $\pm$ 25 % pour les valeurs éloignées du zéro et à $\pm$ 4 unités pour les valeurs proches du zéro.

5) Compression et expansion (quantification) suivant la revendication 4, caractérisées en ce que la caractéristique de quantification d'un signal à codage MIC à 8 éléments binaires, mais en convention négative, correspond auxdits tableaux I et II, mais dans lesquels les signes de $d_n$ et $\hat{d}_n$ sont inversés.

6) Compression et expansion (quantification) suivant la revendication 4 ou 5, le signal MIC à traiter comportant n éléments binaires, au lieu de 8, caractérisées en ce que les valeurs de seuils et des niveaux de reconstruction desdits tableaux I et II sont multipliées par $2^{n-8}$.

7) Compression et expansion (quantification) de signaux numériques de télévision à codage différentiel MICD dont la caractéristique de quantification, qui est définie par le nombre et les valeurs des seuils et des niveaux de reconstruction, varie suivant la valeur de la prédiction $P_n$ concernant le point à coder, la gamme de variation de la prédiction $P_n$ étant découpée en zones de prédiction $Z_i$, i variant de 1 à k, à chaque zone de prédiction $Z_i$ étant associée une caractéristique de quantification $Q_i$, qui est invariante pour toutes les valeurs $X_n$ de l'échantillon à coder dont la valeur de prédiction $P_n$ est incluse dans la zone $Z_i$, mais variant d'une zone $Z_i$ à une autre, chaque caractéristique de quantification $Q_i$ comportant le même nombre $N$ de valeurs de seuils et de niveaux de reconstruction, mais des niveaux extrêmes négatifs et positifs différents d'une zone de prédiction $Z_i$ à une autre, caractérisées en ce que les zones de prédiction $Z_i$ ne sont pas symétriques par rapport à la mi-dynamique de la prédiction $P_n$.

8) Compression et expansion (quantification) suivant la revendication 7, caractérisées en ce que les caractéristiques de quantification $Q_i$ (seuils et niveaux) sont non symétriques les unes des autres par rapport au point correspondant à la mi-dynamique de $P_n$, les zones de prédiction $Z_i$ étant symétriques.

9) Compression et expansion (quantification) suivant l'une des revendications 7 ou 8, caractérisées en ce que les caractéristiques de quantification $Q_i$ sont des segments d'une caractéristique de quantification Q', laquelle comporte un nombre de niveaux $N'$ plus important que $N$.

10) Compression et expansion (quantification) suivant la revendication 7 et 9 ou 8 et 9, caractérisées en ce que la caractéristique de quantification étendue Q' est dissymétrique au sens de l'une des revendications 1 à 3.

1/6

0012632

## FIG.1

## FIG.2

## FIG.4

## FIG.5

# FIG.3

FIG.6A

FIG.6B

0012632

# FIG.7

# FIG.8

# FIG.9

0012632

FIG.10

FIG.11

FIG.12

**Office européen des brevets**

**RAPPORT DE RECHERCHE EUROPEENNE**

0012632
Numéro de la demande

EP 79 40 0067

| Catégorie | Citation du document avec indication, en cas de besoin, des parties pertinentes | Revendication concernée |
|---|---|---|
| X | <u>DE - A - 2 643 761</u> (LICENTIA)<br><br>* Page 3, ligne 24 - page 4, ligne 31 * | 1,8,10 |
| | <br>INTERNATIONALE ELEKTRONISCHE RUND-SCHAU, vol. 27, no. 1, janvier 1973<br>Berlin (DE)<br>R. KERSTEN et W. DIETZ: "Experimente zur Nachrichtenreduktion bei Bildfernsprechsignalen", pages 8-12<br><br>* Page 8, colonne de droite, troisième alinéa - page 9, colonne de gauche, ligne 13 * | 3,4,6 |
| | <br>RADIO MENTOR ELECTRONIC, vol. 39, no. 1, janvier 1973, page 28<br>München (DE)<br>B. WENDLAND et F. MAY: "Ein adaptiver intra-frame Codierer für Fernsehsignale"<br><br>* Figure 9d * | 4 |
| A | <u>DE - A - 2 124 060</u> (FUJITSU)<br><br>* Page 3, ligne 8 - page 9, ligne 11 * | 1,3,7,9 |
| L | <u>FR - A - 2 408 945</u> (TELEDIFFUSION DE FRANCE) 8 juin 1979 | 1-6 |

**DOCUMENTS CONSIDERES COMME PERTINENTS**

**CLASSEMENT DE LA DEMANDE (Int. Cl.³)**

H C4 N 7/12
H 04 B 12/04

**DOMAINES TECHNIQUES RECHERCHES (Int. Cl.³)**

H 04 N 7/00
H 04 B 12/04

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

Le présent rapport de recherche a été établi pour toutes les revendications

| Lieu de la recherche | Date d'achèvement de la recherche | Examinateur |
|---|---|---|
| La Haye | 04-09-1979 | DE ROECK |

OEB Form 1503.1  06.78